# EUROPEAN PATENT APPLICATION

(11) **EP 4 672 875 A1**
(43) Date of publication of application: **31.12.2025**
(21) Application number: 24788098.2
(22) Date of filing: 10.04.2024
(51) Int. Cl.: H05K 3/42, H05K 3/00, H05K 3/46

(54) **PRINTED CIRCUIT BOARD MANUFACTURING METHOD AND PRINTED CIRCUIT BOARD**

(30) Priority: 10.04.2023 CN 202310372233
(71) Applicant: Ruijie Networks Co., Ltd., Fuzhou, Fujian 350002 (CN)
(72) Inventor: LIAO, Zaiyi, Fuzhou, Fujian 350002 (CN); HU, Dongdong, Fuzhou, Fujian 350002 (CN); YANG, Peihang, Fuzhou, Fujian 350002 (CN)
(74) Representative: Boult Wade Tennant LLP
(86) International application number: PCT/CN2024/086993
(87) International publication number: WO 2024/212996

(57) **Abstract**

This application relates to the field of communication technology, and in particular, to a printed circuit board manufacturing method and a printed circuit board. The method includes: forming a through hole in a multilayer printed circuit board that runs through the multilayer circuit board, where the multilayer printed circuit board is provided with an upper printed circuit board, a wiring layer, and a lower printed circuit board that are stacked; forming a blind hole from the upper printed circuit board to the wiring layer in the multilayer circuit board; drilling between the through hole and the blind hole to form a connection groove, where the through hole is in communication with the blind hole through the connection groove; and allowing an electrolyte solution to flow through the through hole, the connection groove, and the blind hole to form a conductive layer, achieving an electrical connection between the upper printed circuit board and the lower printed circuit board.

## Description

### CROSS-REFERENCE TO RELATED APPLICATIONS

This application claims priority to Chinese Patent Application No. 202310372233.3, filed on April 10, 2023 and entitled "METHOD FOR FORMING BLIND HOLE IN HIGH-SPEED PRINTED CIRCUIT BOARD AND PRINTED CIRCUIT BOARD", which is incorporated herein by reference in its entirety.

### TECHNICAL FIELD

This application relates to the field of communication technology, and in particular, to a printed circuit board manufacturing method and a printed circuit board.

### BACKGROUND

With the continuous increase in signal transmission rates of high-speed interconnect links, the printed circuit board, as a carrier for devices and signal transmission, has an increasingly significant impact on the electrical performance of communication systems due to its signal integrity. In addition, to enable faster signal conduction on the printed circuit board, blind holes are typically formed within the printed circuit board.

### SUMMARY

Various example embodiments of this application disclose a printed circuit board manufacturing method and a printed circuit board.

To achieve the above objectives, embodiments of this application provide the following technical solutions:
According to a first aspect, an embodiment of this application provides a printed circuit board manufacturing method, including:
forming a through hole in a multilayer printed circuit board that runs through the multilayer circuit board, where the multilayer printed circuit board is provided with an upper printed circuit board, a wiring layer, and a lower printed circuit board that are stacked;
forming a blind hole from the upper printed circuit board to the wiring layer in the multilayer circuit board;
drilling between the through hole and the blind hole to form a connection groove, where the through hole is in communication with the blind hole through the connection groove; and
allowing an electrolyte solution to flow through the through hole, the connection groove, and the blind hole to form a conductive layer, where the conductive layer is configured to electrically connect the upper printed circuit board and the lower printed circuit board.

In some embodiments, the forming a through hole in a multilayer printed circuit board that runs through the multilayer circuit board includes:
drilling a reflow hole in the multilayer printed circuit board using a mechanical drill, where the reflow hole runs through the multilayer printed circuit board.

In some embodiments, the forming a blind hole from the upper printed circuit board to the wiring layer in the multilayer circuit board includes:
drilling from the upper printed circuit board to a first hole position using a mechanical drill, where a distance between a bottom surface of the first hole position and an upper surface of the wiring layer is within a first preset range; and
drilling from the bottom surface of the first hole position to the upper surface of the wiring layer using laser.

In some embodiments, the drilling between the through hole and the blind hole to form a connection groove specifically includes:
drilling between the through hole and the blind hole using a mechanical drill to form the connection groove.

In some embodiments, the drilling between the through hole and the blind hole using a mechanical drill includes:
drilling between the through hole and the blind hole using the mechanical drill through a method for forming a gourd-shaped hole, where the gourd-shaped hole partially overlaps with the through hole and the blind hole, respectively.

In some embodiments, the allowing an electrolyte solution to flow through the through hole, the connection groove, and the blind hole to form the conductive layer includes:
allowing the electrolyte solution to flow through the through hole, the connection groove, and the blind hole to form the conductive layer on an inner side of the through hole, an inner side of the connection groove, and an inner side of the blind hole.

In some embodiments, after the allowing an electrolyte solution to flow through the through hole, the connection groove, and the blind hole to form a conductive layer, the method further includes:
cutting the conductive layer interior to the connection groove off; and
filling the connection groove with a filling medium.

In some embodiments, the cutting the conductive layer interior to the connection groove off includes:
drilling through the conductive layer using a mechanical drill in a region covered by an orthographic projection of the connection groove on the multilayer printed circuit board.

In some embodiments, a bottom surface of the connection groove is higher or lower than a lower surface of the wiring layer.

In some embodiments, before the filling the connection groove with a filling medium, the method further includes:
removing burrs interior to the connection groove using a mechanical drill.

In some embodiments, an opening arc degree of the blind hole and an opening arc degree of the through hole are the same or different.

In some embodiments, the opening arc degree of the blind hole ranges from 180 degrees to 360 degrees, and/or the opening arc degree of the through hole ranges from 180 degrees to 360 degrees.

In some embodiments, a distance between a center of the through hole and a center of the blind hole is less than 40 mils.

In some embodiments, the filling medium is a dielectric medium.

According to a second aspect, an embodiment of this application further provides a printed circuit board, where the printed circuit board is prepared using the printed circuit board manufacturing method as described above.

According to a third aspect, an embodiment of this application provides a printed circuit board manufacturing method, including the following steps:
S100: providing an upper printed circuit board, a wiring layer, and a lower printed circuit board, and laminating the upper printed circuit board, the wiring layer, and the lower printed circuit board as a whole to form a multilayer printed circuit board;
S200: forming a reflow hole in the multilayer printed circuit board that runs through the multilayer printed circuit board;
S300: forming a signal hole extending to the wiring layer in the multilayer printed circuit board;
S400: forming a connection groove in the multilayer printed circuit board to enable communication between the signal hole and the reflow hole;
S500: removing a medium between an inner side of the signal hole and the wiring layer inside the signal hole to precisely form the signal hole on a surface of the wiring layer;
S600: performing electroplating to electrically connect the upper printed circuit board and the lower printed circuit board and electrically connect the signal hole and the reflow hole;
S700: cutting off an electrical connection between the signal hole and the reflow hole; and
S800: filling the connection groove between the signal hole and the reflow hole with a filling medium.

In the method for forming the signal hole provided in this embodiment of this application, the reflow hole and the signal hole are first formed in the multilayer printed circuit board, and the reflow hole is in communication with the signal hole through the connection groove. Therefore, when the method is applied to a thick multilayer printed circuit board, the reflow hole is first drilled through in the multilayer printed circuit board, then the signal hole is drilled to a position of the wiring layer, and the signal hole is connected to the wiring layer through a laser drilling technology. This allows the electrolyte solution to enter the connection groove and the signal hole through the reflow hole, ensures the flow of the electrolyte solution among the three, and achieves electroplating, further achieving an electrical connection among the upper printed circuit board, the wiring layer, and the lower printed circuit board, and ensuring high-speed signal transmission. The method can be applied to multilayer printed circuit boards of different thicknesses, achieving electroplating between the signal hole and the multilayer printed circuit board, thereby improving the practicability.

In some embodiments, S200 specifically includes the following step: drilling the reflow hole in the multilayer printed circuit board using a mechanical drill, where the reflow hole runs through the multilayer printed circuit board.

In some embodiments, S300 specifically includes the following step: drilling a signal hole in the multilayer printed circuit board using a mechanical drill, where the signal hole runs through the upper printed circuit board, and the signal hole is connected to the wiring layer.

In some embodiments, S400 specifically includes the following step: drilling between the signal hole and the reflow hole using a conventional mechanical drill to form the connection groove.

In some embodiments, S600 specifically includes the following step: electroplating the signal hole and the reflow hole as a whole using an electrolyte solution to form a conductive layer, where the conductive layer is configured to electrically connect the wiring layer to the upper printed circuit board and the lower printed circuit board, and the signal hole and the reflow hole are electrically connected to each other through the conductive layer.

In some embodiments, S700 specifically includes the following step: drilling through the conductive layer using a mechanical drill in a region covered by an orthographic projection of the connection groove on the multilayer printed circuit board.

In some embodiments, opening arc degrees C of the signal hole and the reflow hole both satisfy the following range: 180° < C < 360°.

In some embodiments, S800 specifically includes the following step: removing burrs interior to the connection groove using a mechanical drill to make the inner side of the connection groove regular.

In some embodiments, the filling medium includes resin.

According to a fourth aspect, an embodiment of this application further provides a printed circuit board applied to the method for forming a blind hole in a high-speed flexible circuit board according to any one of the foregoing embodiments, including: a multilayer printed circuit board, a reflow hole, a signal hole, and a filling medium; where
the multilayer printed circuit board includes an upper printed circuit board, a wiring layer, and a lower printed circuit board, where the upper printed circuit board and the lower printed circuit board are respectively disposed on two sides of the wiring layer facing away from each other; the reflow hole sequentially runs through the upper printed circuit board, the wiring layer, and the lower printed circuit board; the signal hole runs through the upper printed circuit board and is connected to the wiring layer; a connection groove is provided between the reflow hole and the signal hole; and the filling medium is provided inside the connection groove.

### BRIEF DESCRIPTION OF DRAWINGS

To more clearly illustrate the technical solutions in the embodiments of this application or in the conventional technology, the drawings required for describing the embodiments or the conventional technology are briefly introduced below. It is apparent that the drawings described below are only some embodiments of this application, and those of ordinary skill in the art can obtain drawings of other embodiments based on these drawings without creative efforts.

The drawings described herein are provided to further understand this application and constitute a part of this application. The example embodiments and their descriptions are used to explain this application and do not constitute an improper limitation of this application. In the drawings:
FIG. 1 is a schematic flowchart of a printed circuit board manufacturing method according to an embodiment of this application.
FIG. 2 is a schematic flowchart of a printed circuit board manufacturing method according to an embodiment of this application.
FIG. 3 is a schematic flowchart of a specific process of a printed circuit board manufacturing method according to an embodiment of this application.
FIG. 4 is a top view of a signal hole and a reflow hole without a filling medium installed after formation according to an embodiment of this application.
FIG. 5 is a top view of a signal hole and a reflow hole with a filling medium installed after formation according to an embodiment of this application.
FIG. 6 is a partial schematic diagram of an interior of a multilayer printed circuit board without a filling medium installed according to an embodiment of this application.
FIG. 7 is a partial schematic diagram of an interior of a multilayer printed circuit board with a filling medium installed according to an embodiment of this application.

Description of reference signs: 1. multilayer printed circuit board; 11. upper printed circuit board; 12. wiring layer; 13. lower printed circuit board; 2. reflow hole; 3. signal hole; 4. conductive layer; 5. connection groove; and 6. filling medium.

### DESCRIPTION OF EMBODIMENTS

The technical solutions in the embodiments of this application will be clearly and thoroughly described below in conjunction with the drawings in the embodiments of this application. It is apparent that the described embodiments are only some rather than all embodiments of this application. Based on the embodiments in this application, all other embodiments obtained by those of ordinary skill in the art without creative efforts fall within the scope of protection of this application.

A blind hole formation method involves first drilling to a position near a wiring layer inside a printed circuit board using a mechanical depth-controlled drill, then removing a remaining medium using laser to achieve zero stub, but blind holes formed by the method, due to the issues of electrolyte solution exchange, are typically formed with a depth of only 10 mils and with an aspect ratio (a ratio of a hole depth to a hole width) of only about 1:1, resulting in a low electroplating aspect ratio. However, the thickness of printed circuit boards may reach 200 mils. Compared to the thickness of the printed circuit board, the blind hole depth is far insufficient, limiting the application of laser blind holes and making it impossible to effectively electroplate inside the blind holes in thick printed circuit boards.

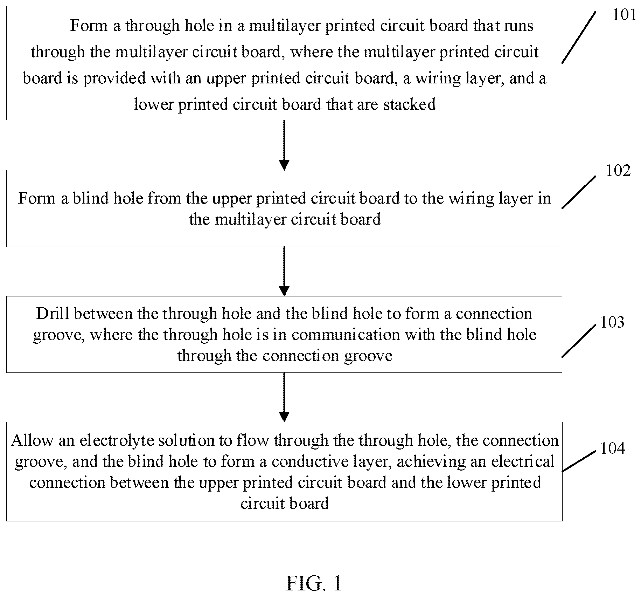

As shown in FIG. 1, an embodiment of this application provides a printed circuit board manufacturing method, including the following steps.

Step 101: Form a through hole in a multilayer printed circuit board that runs through the multilayer circuit board, where the multilayer printed circuit board is provided with an upper printed circuit board, a wiring layer, and a lower printed circuit board that are stacked.

Step 102: Form a blind hole from the upper printed circuit board to the wiring layer in the multilayer circuit board.

In an embodiment, drilling may be performed from the upper printed circuit board to a first hole position using a mechanical drill. A distance between a bottom surface of the first hole position and an upper surface of the wiring layer is within a first preset range. That is, the first hole position is located in a region near the upper surface of the wiring layer, which may be located in the printed circuit board adjacent to the upper surface of the wiring layer. Therefore, the first preset range is related to a thickness of the printed circuit board adjacent to the upper surface of the wiring layer, for example, not exceeding the thickness of the printed circuit board adjacent to the upper surface of the wiring layer, such as 2 mils to 10 mils.

Then, a medium at the first hole position and the wiring layer hole position is removed through a laser via technology to form the blind hole on a surface of the wiring layer.

Step 103: Drill between the through hole and the blind hole to form a connection groove, where the through hole is in communication with the blind hole through the connection groove.

In an embodiment, drilling is performed in a stacking direction of the multilayer printed circuit board to form the connection groove, where the connection groove is located between the through hole and the blind hole and enables communication between the through hole and the blind hole.

Step 104: Allow an electrolyte solution to flow through the through hole, the connection groove, and the blind hole to form a conductive layer, achieving an electrical connection between the upper printed circuit board and the lower printed circuit board.

In an embodiment, after the allowing an electrolyte solution to flow through the through hole, the connection groove, and the blind hole to form a conductive layer, the method further includes:
cutting the conductive layer interior to the connection groove off; and
filling the connection groove with a filling medium.

In some embodiments, the forming a through hole in a multilayer printed circuit board that runs through the multilayer circuit board includes:
drilling a reflow hole in the multilayer printed circuit board using a mechanical drill, where the reflow hole runs through the multilayer printed circuit board.

In some embodiments, the forming a blind hole from the upper printed circuit board to the wiring layer in the multilayer circuit board includes:
drilling from the upper printed circuit board to a first hole position using a mechanical drill, where a distance between a bottom surface of the first hole position and an upper surface of the wiring layer is within a first preset range; and
drilling from the bottom surface of the first hole position to the upper surface of the wiring layer using laser.

In some embodiments, the drilling between the through hole and the blind hole to form a connection groove specifically includes:
drilling between the through hole and the blind hole using a mechanical drill to form the connection groove.

In some embodiments, the drilling between the through hole and the blind hole using a mechanical drill includes:
drilling between the through hole and the blind hole using the mechanical drill through a method for forming a gourd-shaped hole, where the gourd-shaped hole partially overlaps with the through hole and the blind hole, respectively.

In some embodiments, the allowing an electrolyte solution to flow through the through hole, the connection groove, and the blind hole to form the conductive layer includes:
allowing the electrolyte solution to flow through the through hole, the connection groove, and the blind hole to form the conductive layer on an inner side of the through hole, an inner side of the connection groove, and an inner side of the blind hole.

In some embodiments, after the allowing an electrolyte solution to flow through the through hole, the connection groove, and the blind hole to form a conductive layer, the method further includes:
cutting the conductive layer interior to the connection groove off; and
filling the connection groove with a filling medium.

In some embodiments, the cutting the conductive layer interior to the connection groove off includes:
drilling through the conductive layer using a mechanical drill in a region covered by an orthographic projection of the connection groove on the multilayer printed circuit board.

In some embodiments, a bottom surface of the connection groove is lower than a lower surface of the wiring layer.

In some embodiments, before the filling the connection groove with a filling medium, the method further includes: removing burrs interior to the connection groove using a mechanical drill.

In some embodiments, an opening arc degree of the blind hole and an opening arc degree of the through hole are the same or different.

In some embodiments, the opening arc degree of the blind hole ranges from 180 degrees to 360 degrees, and/or the opening arc degree of the through hole ranges from 180 degrees to 360 degrees.

In some embodiments, a distance between a center of the through hole and a center of the blind hole is less than 40 mils.

In some embodiments, the filling medium is a dielectric medium.

In this embodiment of this application, a high-speed via structure is first formed on the multilayer printed circuit board. The high-speed via structure includes a signal hole and a reflow hole, where the reflow hole is a through hole, and the signal hole is a blind hole. The reflow hole and the signal hole are in communication with each other through a connection groove. Thus, when this embodiment of this application is applied to a thick multilayer printed circuit board, the reflow hole is first drilled through in the multilayer printed circuit board, then the signal hole is drilled to the position of the wiring layer, and the signal hole is formed on the surface of the wiring layer. This allows the electrolyte solution to enter the connection groove and the signal hole through the reflow hole, ensures the flow of the electrolyte solution among the three, and achieves electroplating, further achieving an electrical connection among the upper printed circuit board, the wiring layer, and the lower printed circuit board 13, and ensuring high-speed signal transmission. This embodiment of this application can be applied to multilayer printed circuit boards of different thicknesses, achieving electroplating between the signal hole and the multilayer printed circuit board, thereby improving the practicality.

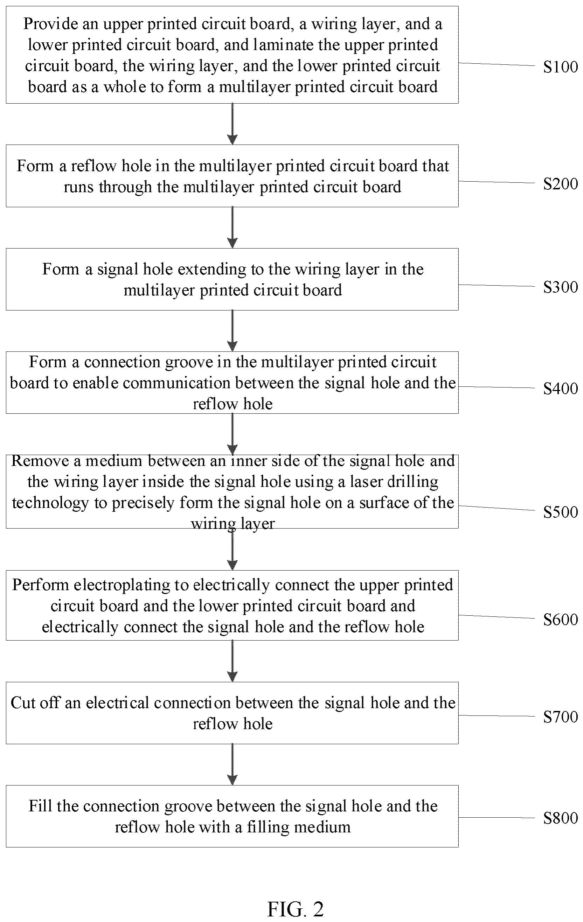

As shown in FIGs. 2 to 7, various example embodiments of this application provide a printed circuit board manufacturing method, including the following steps.

S100: Provide an upper printed circuit board 11, a wiring layer 12, and a lower printed circuit board 13, and laminate the upper printed circuit board 11, the wiring layer 12, and the lower printed circuit board 13 as a whole to form a multilayer printed circuit board 1.

S200: Form a reflow hole 2 in the multilayer printed circuit board 1 that runs through the multilayer printed circuit board 1.

S300: Form a signal hole 3 from the upper printed circuit board 11 to the wiring layer 12 in the multilayer printed circuit board 1.

S400: Form a connection groove 5 in the multilayer printed circuit board 1 to enable communication between the signal hole 3 and the reflow hole 2.

S500: Remove a medium between an inner side of the signal hole 3 and the wiring layer 12 inside the signal hole 3 to precisely form the signal hole 3 on a surface of the wiring layer 12.

S600: Perform electroplating to electrically connect the upper printed circuit board 11 and the lower printed circuit board 13 and electrically connect the signal hole 3 and the reflow hole 2.

S700: Cut off an electrical connection between the signal hole 3 and the reflow hole 2.

S800: Fill the connection groove 5 between the signal hole 3 and the reflow hole 2 with a filling medium 6.

In the method for forming the signal hole 3 provided in the embodiments of this application, the reflow hole 2 and the signal hole 3 are first formed in the multilayer printed circuit board 1, and the reflow hole 2 is in communication with the signal hole 3 through the connection groove 5. Therefore, when the embodiments of this application are applied to a thick multilayer printed circuit board 1, the reflow hole 2 is first drilled through in the multilayer printed circuit board 1, then the signal hole 3 is drilled to a position of the wiring layer 12, and the signal hole 3 is connected to the wiring layer 12 through a laser drilling technology. This allows the electrolyte solution to enter the connection groove 5 and the interior of the signal hole 3 through the reflow hole 2, ensures the flow of the electrolyte solution among the three, and achieves electroplating, further achieving an electrical connection between the upper printed circuit board 11, the wiring layer 12, and the lower printed circuit board 13, and ensuring high-speed signal transmission. The embodiments of this application can be applied to multilayer printed circuit boards 1 of different thicknesses, achieving electroplating between the signal hole 3 and the multilayer printed circuit board 1, thereby improving the practicality.

In a possible implementation, S200 specifically includes the following step: drilling the reflow hole 2 in the multilayer printed circuit board 1 using a mechanical drill, where the reflow hole 2 runs through the multilayer printed circuit board 1. When the embodiments of this application are used, the size of the reflow hole 2 can be adjusted according to actual needs during formation of the reflow hole 2. In the process of changing the diameter of the reflow hole 2, mechanical drills of different diameters may be used for drilling in the embodiments of this application. The embodiments of this application do not specifically limit a drill bit used for drilling. It should be noted that a distance between a center of the reflow hole 2 and a center of the signal hole 3 is typically less than 40 mils, with a typical value of 24 mils. However, the distance may be changed according to actual needs. This is not specifically limited in the embodiments of this application.

In a possible implementation, S300 specifically includes the following step: drilling the signal hole 3 using a mechanical drill in the multilayer printed circuit board 1, where the signal hole 3 runs through the upper printed circuit board 11, and the signal hole 3 is connected to the wiring layer 12. The signal hole 3 primarily serves to transmit signals in the multilayer printed circuit board 1 and thus needs to be connected to the wiring layer 12 in the multilayer printed circuit board 1. When the multilayer printed circuit board 1 is thick, the laser drilling technology cannot drill through the multilayer printed circuit board 1. Therefore, it is necessary to first drill through the multilayer printed circuit board 1 using a mechanical drill, followed by the laser drilling technology to remove a medium between the signal hole 3 and the wiring layer 12. In addition, since a copper layer on the wiring layer 12 can stop the laser, the via can be precisely stopped at the wiring layer 12, achieving zero stub.

In a possible implementation, S400 specifically includes the following step: drilling between the signal hole 3 and the reflow hole 2 using a conventional mechanical drill to form the connection groove 5. In the above step, to facilitate the flow of the electrolyte solution between the signal hole 3 and the reflow hole 2, it is necessary to drill between the signal hole 3 and the reflow hole 2 for enabling communication therebetween. The method adopted in the embodiments of this application involves drilling using a mechanical drill, enabling communication between the signal hole 3 and the reflow hole 2 through a method for forming a gourd-shaped hole (overlapping hole), and further forming the connection groove 5, thereby facilitating the flow of the electrolyte solution. The drilling through the method for forming the gourd-shaped hole involves forming a structure with multiple overlapping holes through drilling.

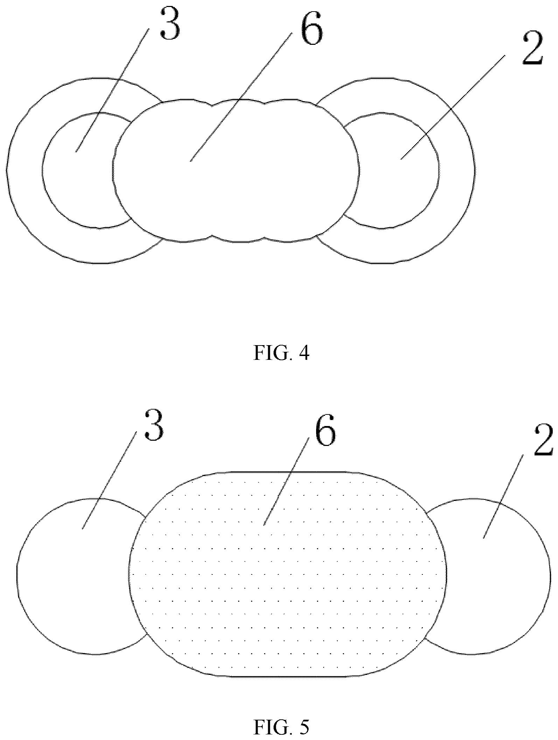

In a possible implementation, referring to FIG. 5, S600 specifically includes the following step: electroplating the signal hole 3 and the reflow hole 2 as a whole using an electrolyte solution to form a conductive layer 4, where the conductive layer 4 is configured to electrically connect the wiring layer 12, the upper printed circuit board 11, and the lower printed circuit board 13. In addition, the signal hole 3 and the reflow hole 2 are electrically connected to each other through the conductive layer 4. Specifically, as shown in FIG. 5, a flow direction of the electrolyte solution is indicated by arrow A, that is, a direction from the lower printed circuit board 13 to the upper printed circuit board 11. During the electroplating process, metal in the electrolyte solution adheres to the inner sides of the reflow hole 2, the connection groove 5, and the signal hole 3 to form the conductive layer 4. The conductive layer 4 inside the reflow hole 2, the connection groove 5, and the signal hole 3 is configured to electrically connect the upper printed circuit board 11 and the lower printed circuit board 13, facilitating signal transmission. It should be noted that since the electroplated conductive layer 4 has a certain thickness, the conductive layer 4 partially protrudes from the upper surface of the upper printed circuit board 11 on the surface of the upper printed circuit board 11. However, in practical operation, the protruding thickness does not affect actual use.

In a possible implementation, S700 specifically includes the following step: drilling through the conductive layer 4 using a mechanical drill in a region covered by an orthographic projection of the connection groove 5 on the multilayer printed circuit board 1. This step involves manually cutting the conductive layer 4 interior to the connection groove 5 off and filling it with a filling medium 6, further cutting off the electrical connection between the reflow hole 2 and the signal hole 3 to avoid short circuits during use. It should be noted that the filling medium 6 in the embodiments of this application is only used to fill the connection groove 5, and whether or how the signal hole 3 and the reflow hole 2 are filled during use depends on actual needs. This is not specifically limited in the embodiments of this application.

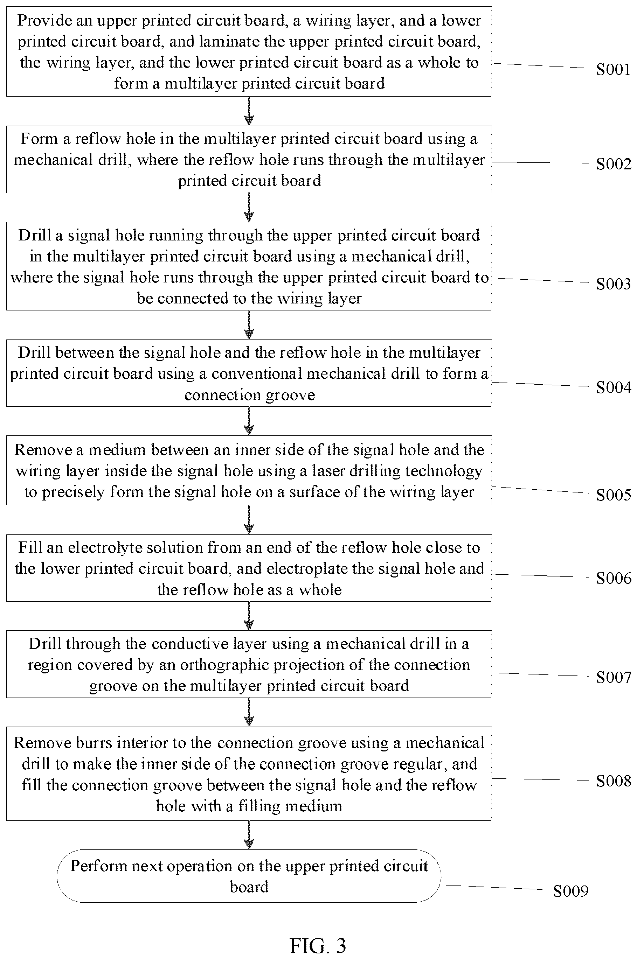

In a possible implementation, referring to FIGs. 3 and 4, opening arc degrees C of the signal hole 3 and the reflow hole 2 both satisfy the following range: 180° < C < 360°. In the above step, since the sizes of the mechanical drills used may be the same or different, the opening arc degrees C of the signal hole 3 and the reflow hole 2 may be the same or different. However, based on this, the opening arc degrees C need to be greater than 180° to enable better electrical connection between the signal hole 3 and the wiring layer 12, facilitating high-speed signal transmission.

In a possible implementation, S800 specifically includes the following step: removing burrs interior to the connection groove 5 using a mechanical drill to make the inner side of the connection groove 5 regular. In the embodiments of this application, in the above step, before the connection groove 5 is sealed, the burrs on the inner side of the connection groove 5 need to be removed, facilitating the sealing of the connection groove 5 with a solid filling medium 6, thereby facilitating further wiring processing on the surface of the multilayer printed circuit board 1.

In a possible implementation, the filling medium 6 includes resin. The filling medium 6 used is an insulating material, which can avoid short circuits in the conductive layer 4.

To make the solutions provided by the embodiments of this application easier to understand, a high-speed printed circuit board manufacturing method provided by the embodiments of this application is described in detail below through a specific embodiment. As shown in FIG. 2, the process includes the following steps.

S001: Provide an upper printed circuit board, a wiring layer, and a lower printed circuit board, and laminate the upper printed circuit board, the wiring layer, and the lower printed circuit board as a whole to form a multilayer printed circuit board, and proceed to S002.

S002: Form a reflow hole in the multilayer printed circuit board using a mechanical drill, where the reflow hole runs through the multilayer printed circuit board; and proceed to S003.

S003: Drill a signal hole running through the upper printed circuit board in the multilayer printed circuit board using a mechanical drill, where the signal hole runs through the upper printed circuit board to be connected to the wiring layer; and proceed to S004.

S004: Drill between the signal hole and the reflow hole in the multilayer printed circuit board using a conventional mechanical drill to form a connection groove, and proceed to S005.

S005: Remove a medium between an inner side of the signal hole and the wiring layer inside the signal hole using a laser drilling technology to precisely form the signal hole on a surface of the wiring layer, and proceed to S006.

S006: Fill an electrolyte solution from an end of the reflow hole close to the lower printed circuit board, and electroplate the signal hole and the reflow hole as a whole to form a conductive layer; and proceed to S007.

S007: Drill through the conductive layer using a mechanical drill in a region covered by an orthographic projection of the connection groove on the multilayer printed circuit board, and proceed to S008.

S008: Remove burrs interior to the connection groove using a mechanical drill to make the inner side of the connection groove regular, and fill the connection groove between the signal hole and the reflow hole with a filling medium; and proceed to S009.

S009: Perform next operation on the upper printed circuit board.

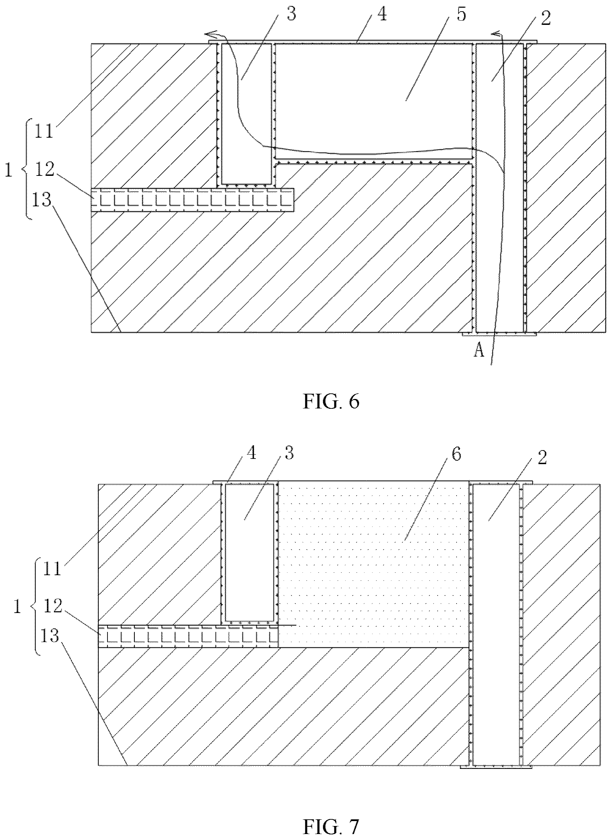

In a possible implementation, referring to FIGs. 5 and 6, an embodiment of this application further provides a printed circuit board, applied to the blind hole formation method according to any one of the foregoing embodiments, including: a multilayer printed circuit board 1, a reflow hole 2, a signal hole 3, and a filling medium 6.

The multilayer printed circuit board 1 includes an upper printed circuit board 11, a wiring layer 12, and a lower printed circuit board 13, where the upper printed circuit board 11 and the lower printed circuit board 13 are respectively disposed on two sides of the wiring layer 12 facing away from each other. The reflow hole 2 sequentially runs through the upper printed circuit board 11, the wiring layer 12, and the lower printed circuit board 13. The signal hole 3 runs through the upper printed circuit board 11 and is connected to the wiring layer 12. A connection groove 5 is provided between the reflow hole 2 and the signal hole 3. The filling medium 6 is disposed inside the connection groove 5. Specifically, referring to FIGs. 6 and 7, the signal hole 3 formed by the above formation method is shown in the figures. The signal hole 3 formed by the method can achieve zero stub of the signal hole 3 to the greatest extent, enabling high-speed signal transmission to the greatest extent.

It is apparent that those skilled in the art can make various modifications and variations to this application without departing from the spirit and scope of this application. Thus, if these modifications and variations of this application fall within the scope of the claims of this application and their equivalents, this application is intended to include these modifications and variations.

## Claims

1. A printed circuit board manufacturing method, comprising:
forming a through hole in a multilayer printed circuit board that runs through the multilayer circuit board, wherein the multilayer printed circuit board is provided with an upper printed circuit board, a wiring layer, and a lower printed circuit board that are stacked;
forming a blind hole from the upper printed circuit board to the wiring layer in the multilayer circuit board;
drilling between the through hole and the blind hole to form a connection groove, wherein the through hole is in communication with the blind hole through the connection groove; and
allowing an electrolyte solution to flow through the through hole, the connection groove, and the blind hole to form a conductive layer, wherein the conductive layer is configured to electrically connect the upper printed circuit board and the lower printed circuit board.

2. The method according to claim 1, wherein the forming a through hole in a multilayer printed circuit board that runs through the multilayer circuit board comprises:
drilling a reflow hole in the multilayer printed circuit board using a mechanical drill, wherein the reflow hole runs through the multilayer printed circuit board.

3. The method according to claim 1, wherein the forming a blind hole from the upper printed circuit board to the wiring layer in the multilayer circuit board comprises:
drilling from the upper printed circuit board to a first hole position using a mechanical drill, wherein a distance between a bottom surface of the first hole position and an upper surface of the wiring layer is within a first preset range; and
drilling from the bottom surface of the first hole position to the upper surface of the wiring layer using laser.

4. The method according to claim 1, wherein the drilling between the through hole and the blind hole to form a connection groove comprises:
drilling between the through hole and the blind hole using a mechanical drill to form the connection groove.

5. The method according to claim 4, wherein the drilling between the through hole and the blind hole using a mechanical drill comprises:
drilling between the through hole and the blind hole using the mechanical drill through a method for forming a gourd-shaped hole, wherein the gourd-shaped hole partially overlaps with the through hole and the blind hole, respectively.

6. The method according to claim 1, wherein the allowing an electrolyte solution to flow through the through hole, the connection groove, and the blind hole to form the conductive layer comprises:
allowing the electrolyte solution to flow through the through hole, the connection groove, and the blind hole to form the conductive layer on an inner side of the through hole, an inner side of the connection groove, and an inner side of the blind hole.

7. The method according to claim 1, wherein after the allowing an electrolyte solution to flow through the through hole, the connection groove, and the blind hole to form a conductive layer, the method further comprises:
cutting the conductive layer interior to the connection groove off; and
filling the connection groove with a filling medium.

8. The method according to claim 7, wherein the cutting the conductive layer interior to the connection groove off comprises:
drilling through the conductive layer using a mechanical drill in a region covered by an orthographic projection of the connection groove on the multilayer printed circuit board.

9. The method according to claim 8, wherein a bottom surface of the connection groove is higher or lower than an upper surface of the wiring layer.

10. The method according to claim 7, wherein before the filling the connection groove with a filling medium, the method further comprises: removing burrs interior to the connection groove using a mechanical drill.

11. The method according to claim 1, wherein an opening arc degree of the blind hole and an opening arc degree of the through hole are the same or different.

12. The method according to claim 11, wherein the opening arc degree of the blind hole ranges from 180 degrees to 360 degrees, and/or the opening arc degree of the through hole ranges from 180 degrees to 360 degrees.

13. The method according to claim 1, wherein a distance between a center of the through hole and a center of the blind hole is less than 40 mils.

14. The method according to claim 1, wherein the filling medium is a dielectric medium.

15. A printed circuit board, wherein the printed circuit board is prepared using the printed circuit board manufacturing method according to any one of claims 1 to 14.
